# EUROPEAN PATENT SPECIFICATION

(11) **EP 2 931 803 B1**
(45) Date of publication and mention of the grant of the patent: **19.06.2019**
(21) Application number: 13827037.6
(22) Date of filing: 27.11.2013
(51) Int. Cl.: C08K 5/5419, C08K 3/22, C08L 83/04

(54) **THERMALLY CONDUCTIVE FLAME RETARDANT POLYMER COMPOSITIONS AND USES THEREOF**
WÄRMELEITENDE FLAMMHEMMENDE POLYMERZUSAMMENSETZUNGEN UND VERWENDUNGEN DAVON
COMPOSITIONS DE POLYMÈRE IGNIFUGES THERMOCONDUCTRICES ET LEURS UTILISATIONS

(30) Priority: 14.12.2012 US 201261737539 P
(43) Date of publication of application: 21.10.2015
(73) Proprietor: SABIC Global Technologies B.V., 4612 PX Bergen op Zoom (NL)
(72) Inventor: GUO, Mingcheng, Pudong Shanghai 201319 (CN); ZHANG, Yaqin, Pudong Shanghai 201319 (CN); AN, Yuxian, Pudong Shanghai 201319 (CN)
(74) Representative: Chevalier, Renaud Philippe
(86) International application number: PCT/IB2013/060455
(87) International publication number: WO 2014/091351

(56) References cited:
- WO-A1-2011/010290
- DATABASE WPI Week 201220 Thomson Scientific, London, GB; AN 2012-D03341 XP002723361, -& WO 2012/029421 A1 (NEC CORP) 8 March 2012 (2012-03-08)
- DATABASE WPI Week 200838 Thomson Scientific, London, GB; AN 2008-G03228 XP002723617, -& WO 2008/044471 A1 (NEC CORP) 17 April 2008 (2008-04-17)

## Description

### BACKGROUND

This disclosure relates to a thermally conductive flame retardant polymer composition. The present invention also relates to methods of manufacturing these compositions and articles that comprise these compositions.

Thermoplastic polymer compositions are used for various applications, such as in housings for personnel computers, display devices, electronic device materials, automotive exterior and interior parts, and the like. It is desirable for polymers used in the aforementioned applications to be flame retardant and also to be thermally conductive to dissipate and distribute heat away from heat sensitive portions of the device.

Flame retardant additives are often added to thermoplastic polymer compositions to improve the flame retardancy of the composition. However, the addition of certain flame retardant additives often reduces the thermal conductivity and/or the impact strength of the composition. It is therefore desirable to add compounds that improve the flame retardancy while simultaneously improving the thermal conductivity of the composition.

Since polymer compositions are less thermally conductive than metals, any heat generated in these materials is not easily dissipated to the surrounding. In order to compensate for this deficiency, thermally conducting fillers are added to the thermoplastic polymer compositions. High volume fractions of filler are used to achieve thermal conductivities suitable for efficient heat transport through the thermoplastic polymer composition. Ceramic fillers are often added to the thermoplastic polymer compositions in order to increase the thermal conductivity. The number of ceramic filler types that can currently be used for thermally conductive compositions is relatively limited, since most ceramic fillers are thermally insulating or have a relatively low thermal conductivity. Consequently, ceramic fillers with a high thermal conductivity are expensive to use and the design freedom to control other properties, such as mechanical properties, flow and heat stability, is limited. It is therefore desirable to use improved fillers or combinations thereof that achieve thermally conductive compositions that are inexpensive and that produce flame retardancy when desired.

### SUMMARY

Disclosed herein is a thermally conductive composition, comprising 20 to 80 wt% of a thermoplastic or thermosetting polymer; 10 to 70 wt% of a metal hydroxide; 0.5 to 40 wt% of a silicone char-forming agent, wherein the silicone char-forming agent is an organopolysiloxane selected from polyalkylsiloxane, polyalkylarylsiloxane, polyarylsiloxane, or a combination comprising at least one of the foregoing organopolysiloxanes, or an organopolysiloxane copolymer selected from a polycarbonate-polysiloxane copolymer, a polyamide-polysiloxane copolymer, a polyester-polysiloxane copolymer, a polymethacrylate-polysiloxane copolymer, a polyetherimide-polysiloxane copolymer, a polyphenylene-ether-polysiloxane copolymer, or a combination comprising at least one of the foregoing copolymers;, and 0.05 to 5 wt% of an anti-flame dripping agent, wherein the anti-flame dripping agent is a multi-functional modified styrene-acrylic oligomeric chain extender, a multi-functional amino or carboxyl chain extender, a combination of poly(tetrafluoroethylene) and a styrene-acrylonitrile copolymer, or a combination comprising at least one of the foregoing anti-flame dripping agents, wherein the thermally conductive composition has a thermal conductivity of at least 0.5 W/mK for through plane thermal conductivity; and a flame retardancy of at least V-0 performance at a thickness of 1.2 mm or less when tested as per a UL-94 testing standard.

Disclosed herein too is a method comprising blending 20 to 80 wt% of a thermoplastic or thermosetting polymer; 10 to 70 wt% of a metal hydroxide; 0.5 to 40 wt% of a silicone char-forming agent, and 0.05 to 5 wt% of an anti-flame dripping agent; wherein the thermally conductive composition has a thermal conductivity of at least 0.5 W/mK for through plane thermal conductivity; and a flame retardancy of at least V-0 performance at a thickness of 1.2 mm or less when tested as per a UL-94 testing standard, wherein the silicone char-forming agent is an organopolysiloxane selected from polyalkylsiloxane, polyalkylarylsiloxane, polyarylsiloxane, or a combination comprising at least one of the foregoing organopolysiloxanes, or an organopolysiloxane copolymer selected from a polycarbonate-polysiloxane copolymer, a polyamide-polysiloxane copolymer, a polyester-polysiloxane copolymer, a polymethacrylate-polysiloxane copolymer, a polyetherimide-polysiloxane copolymer, a polyphenylene-ether-polysiloxane copolymer, or a combination comprising at least one of the foregoing copolymers, and wherein the anti-flame dripping agent is a multi-functional modified styrene-acrylic oligomeric chain extender, a multi-functional amino or carboxyl chain extender, a combination of poly(tetrafluoroethylene) and a styrene-acrylonitrile copolymer, or a combination comprising at least one of the foregoing anti-flame dripping agents.

### DETAILED DESCRIPTION

Disclosed herein is a thermally conductive composition having improved flame retardant behavior as well as methods of making these compositions and the articles made therefrom. The thermally conductive compositions comprise a thermoplastic polymer, a metal hydroxide, a silicon-based char-forming agent, optionally fillers or reinforcing agents capable of providing thermal conductivity characteristics and optionally other pigments and/or processing additives. The thermally conductive compositions can be used in a variety of applications such as heat or thermal dissipation management applications where electrical insulation is desired. In an alternative embodiment, thermally conductive compositions can be used in a variety of applications such as heat or thermal dissipation management applications where electrical conductivity is desired. Examples include heat sinks for electronic components in computers and consumer electrical appliances, solar cells and batteries such as processors, lamps, LED-lamps, electric motors, electric circuits, the encapsulation of electronics, such as coils or casings, solar cell back sheets, battery casings, or the manufacture of heat exchangers for highly problematic (corrosive) environments.

In some embodiments, the thermoplastic polymer used in the thermally conductive compositions is an organic polymer. In this embodiment, the organic polymer is selected from a wide variety of thermoplastic polymers or blends of thermoplastic polymers. The thermoplastic polymer may also comprise blends of one or more thermoplastic polymers with one or more thermosetting resins. The thermoplastic polymer can also be a blend of polymers, copolymers, terpolymers, or a combination comprising at least one of the foregoing organic polymers. Examples of the organic polymer are polyethylene (PE), including high-density polyethylene (HDPE), linear low-density polyethylene (LLDPE), low-density polyethylene (LDPE), mid-density polyethylene (MDPE), glycidyl methacrylate modified polyethylene, maleic anhydride functionalized polyethylene, maleic anhydride functionalized elastomeric ethylene copolymers (like EXXELOR® VA1801 and VA1803 from ExxonMobil), ethylene-butene copolymers, ethylene-octene copolymers, ethylene-acrylate copolymers, such as ethylene-methyl acrylate, ethylene-ethyl acrylate, and ethylene butyl acrylate copolymers, glycidyl methacrylate functionalized ethylene-acrylate terpolymers, anhydride functionalized ethylene-acrylate polymers, anhydride functionalized ethylene-octene and anhydride functionalized ethylene-butene copolymers, polypropylene (PP), maleic anhydride functionalized polypropylene, glycidyl methacrylate modified polypropylene, polyacetals, (meth)acryl polymers (which as used herein includes polymers of acrylic acid, methacrylic acid, (C1-C6)alkyl acrylates, (C1-C6)alkyl methacrylates, and copolymers comprising at least one of the foregoing), polycarbonates, polystyrenes, polyesters, polyamides, polyamideimides, polyvinyl chlorides, polypiperazines, polycarboranes, polyoxabicyclononanes, polyacetals, polyanhydrides, polyvinyl ethers, polyvinyl thioethers, polyvinyl alcohols, polyvinyl ketones, polyvinyl halides, polyvinyl nitriles, polyvinyl esters, polysulfonates, polysulfides, polythioesters, polysulfones, polysulfonamides, polyureas, polyphosphazenes, polyurethanes, or the like, or a combination comprising at least one of the foregoing organic polymers.

Thermosetting polymers may also be used. Examples of thermosetting polymers are epoxy polymers, unsaturated polyester polymers, polyimide polymers, bismaleimide polymers, bismaleimide triazine polymers, cyanate ester polymers, vinyl polymers, benzoxazine polymers, benzocyclobutene polymers, acrylics, alkyds, phenol-formaldehyde polymers, novolacs, resoles, melamine-formaldehyde polymers, urea-formaldehyde polymers, hydroxymethylfurans, isocyanates, diallyl phthalate, triallyl cyanurate, triallyl isocyanurate, unsaturated polyesterimides, or the like, or a combination comprising at least one of the foregoing thermosetting polymers.

In an exemplary embodiment, the organic polymer that can be used in the thermally conductive composition is a polyamide, a polyester and a polyolefin.

Accordingly, in some embodiments, an organic polymer that can be used in the conductive composition is a polyamide. The polyamide polymers comprise a generic family of polymers known as nylons, characterized by the presence of an amide group (--C(O)NH--). Any amide-containing polymers can be employed, individually or in combination. Nylon-6 and nylon-6,6 are suitable polyamide polymers available from a variety of commercial sources. Other polyamides, however, such as nylon-4, nylon-4,6 (PA 46), nylon-12, nylon-6,10, nylon-6,9, nylon-6,12, nylon-9T, copolymer of nylon-6,6 and nylon-6, nylon 610 (PA610), nylon 11 (PA11), nylon 12 (PA 12), nylon 6-3-T (PA 6-3-T), polyarylamide (PA MXD 6), polyphthalamide (PPA) and/or poly-ether-block amide, and others such as the amorphous nylons, may also be useful. Mixtures of various polyamides, as well as various polyamide copolymers, are also useful.

The organic polymer is present in the thermally conductive composition in an amount of 10 to 70 wt% (weight percent), specifically 20 to 60 wt%, and more specifically 30 to 50 wt%, based on the total weight of the thermally conductive composition. In an exemplary embodiment, the thermally conductive composition comprises 30 to 45 wt%, based on the total weight of the thermally conductive composition.

In some embodiments, the metal hydroxide may comprise, but is not limited to, Mg(OH)₂ (magnesium hydroxide), γ-AlO(OH) (boehmite), α-AlO(OH) (diaspore), Al(OH)₃ (gibbsite), or the like, or a combination comprising at least one of the foregoing metal hydroxides.

The metal hydroxide may be present in the thermally conductive composition in an amount of 10 to 70 wt%, specifically 15 to 60 wt%, more specifically 17 to 55 wt%, and more specifically 30 to 50 wt%, based on the total weight of the thermally conductive composition.

The silicone char-forming agent forms a silica reinforcing structure in the thermally conductive composition when it is subjected to a flame. The elevated temperatures upon being subjected to the flame facilitate a conversion of the silicone to a silica. The silica acts synergistically with the metal hydroxides to improve the flame retardancy of the thermally conductive composition. The silica reinforcing structure formed as the result of being subjected to a flame is a random structure and is randomly distributed through the bulk of the thermally conductive composition.

The silicone char-forming agents may be present in the thermally conductive composition in an amount of 0.25 to 40 wt%, specifically 1 to 30 wt%, specifically 1.5 to 15 wt%, and more specifically 2 to 10 wt%, based on the total weight of the thermally conductive composition.

In another embodiment, the thermally conductive composition may contain optional impact modifiers. The impact modifiers may comprise aromatic block copolymers. The styrene block copolymers may be a linear block copolymer or a radial block copolymer, and may be of the di-block or tri-block variety. Exemplary styrenic impact modifiers are styrene block copolymers including styrene-butadiene-styrene copolymer (SBS), styrene-(ethylene-butylene)-styrene (SEBS), styrene butadiene rubbers (SBR), acrylonitrile-butadiene-styrene copolymers (ABS), styrenemaleic anhydride (SMA) copolymers, alkyl methacrylate styrene acrylonitrile (AMSAN), methylmethacrylate-butadiene-styrene (MBS), or the like, or a combination comprising at least one of the foregoing impact modifiers. Other suitable impact modifiers include styrene-(ethylene-propylene)-styrene (SEPS), styrene-(ethylene-butene) (SEB), styrene-(ethylene-propylene) (SEP), styrene-isoprene-styrene (SIS), styrene-isoprene, styrene-butadiene, α-methylstyrene-isoprene-α-methylstyrene, α-methylstyrene-butadiene-α-methylstyrene, as well as hydrogenated versions of these block copolymers. Commercially available styrene block copolymers include KRATON available from Shell and K-RESIN available from Chevron Phillips Chemical Company.

The amount of impact modifier present in the thermally conductive composition may be up to 20 wt%, more specifically 5 to 15 wt%, or even more specifically 8 to 10 wt%, based on the total weight of the thermally conductive composition. The thermally conductive composition can contain as low as 1 wt% of the impact modifier.

The thermally conductive composition may also contain a fluorinated anti-drip agent. Fluorinated polyolefin and/or polytetrafluoroethylene may be used as an anti-drip agent. Anti-drip agents may also include a fibril forming or non-fibril forming fluoropolymer such as polytetrafluoroethylene (PTFE). The anti-drip agent may be encapsulated by a rigid copolymer such as, for example styrene acrylonitrile (SAN), PTFE encapsulated in SAN is known as TSAN. Encapsulated fluoropolymers may be made by polymerizing the encapsulating polymer in the presence of the fluoropolymer, for example, in an aqueous dispersion. TSAN may provide significant advantages over PTFE, in that TSAN may be more readily dispersed in the composition. A suitable TSAN may comprise, for example, about 50 wt % PTFE and about 50 wt % SAN, based on the total weight of the encapsulated fluoropolymer. The SAN may comprise, for example, about 75 wt % styrene and about 25 wt % acrylonitrile based on the total weight of the copolymer. Alternatively, the fluoropolymer may be pre-blended in some manner with a second polymer, such as for, example, an aromatic polycarbonate polymer or SAN to form an agglomerated material for use as an anti-drip agent. Either method may be used to produce an encapsulated fluoropolymer.

Anti-drip agents (also referred to herein as anti-flame dripping agents) may be used in amounts of 0.05 to 5 wt%, specifically 0.5 to 2 wt%, based on the total weight of the thermally conductive composition.

In some embodiments, the thermally conductive composition comprises polymeric chain extenders. The polymeric chain extenders comprise multi-functional modified styrene-acrylic oligomers, multi-functional amino or carboxyl or epoxy/glycidyl or anhydride(maleated) or imide chain extenders, or the like, or a combination comprising at least one of the foregoing chain extenders. Examples of polymeric chain extenders are JONCRYL® ADR 4368 and LOTADER® AX8840, AX8900 and AX8950.

The chain extenders are used in amounts of 0.1 to 10 wt%, specifically 0.2 to 5 wt%, and more specifically 0.25 to 2 wt%, based on the total weight of the thermally conductive composition.

Fillers and reinforcing agents may be added to the thermally conductive composition to improve the thermal conductivity of the composition. The thermally conductive composition can have a thermal conductivity of 0.5 W/mK to 25 W/mK when measured as per ASTM E1461 with a sample thickness of 3.0 mm for through plane thermal conductivity and 0.5 mm for in plane thermal conductivity; or measured as per ISO 22007-2 with sample thickness of 3mm for both through and in plane thermal conductivity.

The fillers may have a thermal conductivity that varies from 1 to 500 Watts per meter Kelvin (W/mK) and an electrical conductivity that varies from being insulating (i.e., having an electrical resistivity that is greater than or equal to 10⁵ Ohm.cm) to being electrically conducting (i.e., having an electrical conductivity that is less than or equal to 1 Ohm.cm). These are detailed below.

In some embodiments, the thermally conductive composition comprises optionally added fillers and reinforcing agents that have low thermal conductivity. In other words, low thermally conductive, electrically insulating fillers can be added to the thermally conductive composition. The low thermally conductive, electrically insulative filler has an intrinsic thermal conductivity of about 10 to about 30 W/mK and, in some embodiments, has an electrical resistivity greater than or equal to 10⁵ Ohm.cm. Examples of the low thermally conductive filler are ZnS (zinc sulfide), CaO (calcium oxide), MgO (magnesium oxide), ZnO (zinc oxide), or TiO₂ (titanium dioxide), or the like, or a combination comprising at least one of the foregoing low thermally conductive, electrically insulating fillers.

In some embodiments, one or more high thermally conductive, electrically insulative fillers can be used. The high thermally conductive filler has an intrinsic thermal conductivity greater than or equal to 50 W/mK and, in some embodiments, has an electrical resistivity greater than or equal to 10⁵ Ohm.cm. Examples of the high thermally conductive, electrically insulative filler are AlN (aluminum nitride), BN (boron nitride), MgSiN₂ (magnesium silicon nitride), SiC (silicon carbide), ceramic-coated graphite, or the like, or a combination comprising at least one of the foregoing high thermally conductive, electrically insulative fillers.

In some embodiments, one or more high thermally conductive, electrically conductive fillers can be used. The high thermally conductive, electrically conductive filler has an intrinsic thermal conductivity greater than or equal to 50 W/mK and, in some embodiments, has an electrical resistivity less than or equal to 1 Ohm.cm. Examples of the high thermally conductive, electrically conductive filler are graphite, expanded graphite, graphene, carbon fiber, carbon nanotubes (CNT), or graphitized carbon black, or the like, or a combination comprising at least one of the foregoing high thermally conductive, electrically conductive fillers. In some embodiments, even when electrically conductive fillers are added to the thermally conductive composition, the thermally conductive composition is not rendered electrically conducting, i.e., it is electrically insulating. In another embodiment, the thermally conducting composition may be electrically conducting.

In yet another embodiment, thermally insulating fillers with thermal conductivity lower than 10 W/mK, can be used. These include CaCO₃ (calcium carbonate), mica, BaO (barium oxide), BaSO₄ (barium sulfate), CaSiO₃ (wollastonite), ZrO₂ (zirconium oxide), SiO₂ (silicon oxide), glass beads, glass fiber, MgO•xAl₂O₃ (magnesium aluminate), CaMg(CO₃)₂ (dolomite), H₂Mg₃(SO₃)₄ (talc), ceramic-coated graphite, or a clay; or the like, or a combination comprising at least one of the foregoing thermally insulating fillers.

In yet another embodiment, all of the foregoing thermally conductive fillers can be simultaneously added to the composition.

In some embodiments, fillers and reinforcing agents can be in the shape of particles, flakes or fibers. The fibers can have a circular or non-circular cross section.

The fillers and reinforcing agents may be present in the composition in an amount of 0 to 60 wt%, specifically 5 to 50 wt%, more specifically 10 to 40 wt%, based on the total weight of the thermally conductive composition.

In addition, the thermally conductive compositions may optionally comprise a pigment, dyes and/or colorants. Suitable pigments include for example, inorganic pigments such as metal oxides and mixed metal oxides such as zinc oxide, titanium dioxides, BaSO₄, CaCO₃, BaTiO₃, iron oxides or the like; sulfides such as zinc sulfides, or the like; aluminates; sodium sulfo-silicates; sulfates and chromates; carbon blacks; zinc ferrites; ultramarine blue; Pigment Brown 24; Pigment Red 101; Pigment Yellow 119; Pigment black 28; organic pigments such as azos, di-azos, quinacridones, perylenes, naphthalene tetracarboxylic acids, flavanthrones, isoindolinones, tetrachloroisoindolinones, anthraquinones, anthanthrones, dioxazines, phthalocyanines, and azo lakes; Pigment Blue 60, Pigment Red 122, Pigment Red 149, Pigment Red 177, Pigment Red 179, Pigment Red 202, Pigment Violet 29, Pigment Blue 15, Pigment Green 7, Pigment Yellow 147, Pigment Yellow 150, or the like, or a combination comprising at least one of the foregoing pigments. Pigments are generally used in amounts of 1 to 10 parts by weight, based on 100 parts by weight of the thermally conductive composition.

Suitable dyes include, for example, organic dyes such as coumarin 460 (blue), coumarin 6 (green), nile red or the like; lanthanide complexes; hydrocarbon and substituted hydrocarbon dyes; polycyclic aromatic hydrocarbons; scintillation dyes (preferably oxazoles and oxadiazoles); aryl- or heteroaryl-substituted poly (2-8 olefins); carbocyanine dyes; phthalocyanine dyes and pigments; oxazine dyes; carbostyryl dyes; porphyrin dyes; acridine dyes; anthraquinone dyes; arylmethane dyes; azo dyes; diazonium dyes; nitro dyes; quinone imine dyes; tetrazolium dyes; thiazole dyes; perylene dyes, perinone dyes; bis-benzoxazolylthiophene (BBOT); and xanthene dyes; fluorophores such as anti- stokes shift dyes which absorb in the near infrared wavelength and emit in the visible wavelength, or the like; luminescent dyes such as 5-amino-9-diethyliminobenzo(a)phenoxazonium perchlorate; 7-amino-4-methylcarbostyryl; 7-amino-4-methylcoumarin; 3-(2'-benzimidazolyl)-7-N,N-diethylaminocoumarin; 3-(2'-benzothiazolyl)-7-diethylaminocoumarin; 2-(4-biphenylyl)-5-(4-t-butylphenyl)-1,3,4-oxadiazole; 2-(4-biphenyl)-6-phenylbenzoxazole-1,3; 2,5-Bis-(4-biphenylyl)-1,3,4-oxadiazole; 2,5-bis-(4-biphenylyl)-oxazole; 4,4'-bis-(2-butyloctyloxy)-p-quaterphenyl; p-bis(o-methylstyryl)-benzene; 5,9-diaminobenzo(a)phenoxazonium perchlorate; 4-dicyanomethylene-2-methyl-6-(p-dimethylaminostyryl)-4H-pyran; 1,1'-diethyl-2,2'-carbocyanine iodide; 3,3'-diethyl-4,4',5,5'-dibenzothiatricarbocyanine iodide; 7-diethylamino-4-methylcoumarin; 7-diethylamino-4-trifluoromethylcoumarin; 2,2'-dimethyl-p-quaterphenyl; 2,2-dimethyl-p-terphenyl; 7-ethylamino-6-methyl-4-trifluoromethylcoumarin; 7-ethylamino-4-trifluoromethylcoumarin; nile red; rhodamine 700; oxazine 750; rhodamine 800; IR 125; IR 144; IR 140; IR 132; IR 26; IR5; diphenylhexatriene; diphenylbutadiene; tetraphenylbutadiene; naphthalene; anthracene; 9,10-diphenylanthracene; pyrene; chrysene; rubrene; coronene; phenanthrene or the like, or a combination comprising at least one of the foregoing dyes. Any dyes are generally used in amounts of from 0.1 to 5 parts by weight, based on 100 parts by weight of the thermally conductive composition.

Suitable colorants include titanium dioxide, anthraquinones, perylenes, perinones, indanthrones, quinacridones, xanthenes, oxazines, oxazolines, thioxanthenes, indigoids, thioindigoids, naphthalimides, cyanines, xanthenes, methines, lactones, coumarins, bis-benzoxazolylthiophene (BBOT), napthalenetetracarboxylic derivatives, monoazo and disazo pigments, triarylmethanes, aminoketones, bis(styryl)biphenyl derivatives, or the like, or a combination comprising at least one of the foregoing colorants. Any colorants are generally used in amounts of from 0.1 to 5 parts by weight, based on 100 parts by weight of the thermally conductive composition.

In addition, the thermally conductive compositions may comprise various additives ordinarily incorporated in polymer compositions of this type. Mixtures of additives may be used. Such additives may be mixed at a suitable time during the mixing of the components for forming the composition. The one or more additives are included in the thermoplastic compositions to impart one or more selected characteristics to the thermally conductive compositions and any molded article made therefrom without materially affecting the properties of the molded article containing the composition. Examples of additives that may be included are heat stabilizers, process stabilizers, antioxidants, light stabilizers, plasticizers, antistatic agents, mold releasing agents, UV absorbers, lubricants, flow promoters, impact modifiers or a combination of one or more of the foregoing additives.

Suitable heat stabilizers comprise, for example, organo phosphites such as triphenyl phosphite, tris-(2,6-dimethylphenyl)phosphite, tris-(mixed mono-and dinonylphenyl)phosphite or the like; phosphonates such as dimethylbenzene phosphonate or the like, phosphates such as trimethyl phosphate, or the like, or a combination comprising at least one of the foregoing heat stabilizers. Heat stabilizers are generally used in amounts of 0.01 to 0.5 parts by weight based on 100 parts by weight of the total composition, excluding any filler.

Suitable antioxidants comprise, for example, organophosphites such as tris(nonyl phenyl)phosphite, tris(2,4-di-t-butylphenyl)phosphite, bis(2,4-di-t-butylphenyl)pentaerythritol diphosphite, distearyl pentaerythritol diphosphite or the like; alkylated monophenols or polyphenols; alkylated reaction products of polyphenols with dienes, such as tetrakis[methylene(3,5-di-tert-butyl-4-hydroxyhydrocinnamate)] methane, or the like; butylated reaction products of para-cresol or dicyclopentadiene; alkylated hydroquinones; hydroxylated thiodiphenyl ethers; alkylidene-bisphenols; benzyl compounds; esters of beta-(3,5-di-tert-butyl-4-hydroxyphenyl)-propionic acid with monohydric or polyhydric alcohols; esters of beta-(5-tert-butyl-4-hydroxy-3-methylphenyl)-propionic acid with monohydric or polyhydric alcohols; esters of thioalkyl or thioaryl compounds such as distearylthiopropionate, dilaurylthiopropionate, ditridecylthiodipropionate, octadecyl-3-(3,5-di-tert-butyl-4-hydroxyphenyl)propionate, pentaerythrityl-tetrakis[3-(3,5-di-tert-butyl-4-hydroxyphenyl)propionate, or the like; amides of beta-(3,5-di-tert-butyl-4-hydroxyphenyl)-propionic acid, or the like, or a combination comprising at least one of the foregoing antioxidants. Antioxidants are generally used in amounts of from 0.01 to 0.5 parts by weight, based on 100 parts by weight of the total thermally conductive composition, excluding any filler.

Suitable plasticizers comprise, for example, phthalic acid esters such as dioctyl-4,5-epoxy-hexahydrophthalate, tris-(octoxycarbonylethyl)isocyanurate, tristearin, epoxidized soybean oil, or the like, or a combination comprising at least one of the foregoing plasticizers. Plasticizers are generally used in amounts of 0.5 to 3.0 parts by weight, based on 100 parts by weight of the total thermally conductive composition, excluding any filler.

The thermally conductive composition may include antistatic agents. Examples of antistatic agents include glycerol monostearate, sodium stearyl sulfonate, sodium dodecylbenzenesulfonate, or the like, or a combination comprising at least one of the foregoing antistatic agents. In some embodiments, carbon fibers, carbon nanofibers, carbon nanotubes, carbon black, or a combination comprising at least one of the foregoing carbonaceous materials may be used as antistatic agents to render the thermally conductive composition electrostatically dissipative.

Suitable mold releasing agents comprise for example, metal stearate, stearyl stearate, pentaerythritol tetrastearate, beeswax, montan wax, paraffin wax, or the like, or combinations including at least one of the foregoing mold release agents. Mold releasing agents are generally used in amounts of 0.1 to 1.0 parts by weight, based on 100 parts by weight of the total thermally conductive composition, excluding any filler.

Suitable UV absorbers comprise for example, hydroxybenzophenones; hydroxybenzotriazoles; hydroxybenzotriazines; cyanoacrylates; oxanilides; benzoxazinones; 2- (2H-benzotriazol-2-yl)-4-(1,1,3,3-tetramethylbutyl)-phenol (CYASORB™ 5411); 2-hydroxy-4-n-octyloxybenzophenone (CYASORB™ 531); 2-[4,6-bis(2,4-dimethylphenyl)-1,3,5-triazin-2-yl]-5-(octyloxy)-phenol (CYASORB™ 1164); 2,2'-(1,4- phenylene)bis(4H-3,1-benzoxazin-4-one) (CYASORB™ UV- 3638); 1,3-bis[(2-cyano-3,3-diphenylacryloyl)oxy]-2,2-bis[[(2-cyano-3,3-diphenylacryloyl)oxy]methyl]propane (UVINUL™ 3030); 2,2'-(1,4-phenylene) bis(4H-3,1-benzoxazin-4-one); 1,3-bis[(2-cyano-3,3-diphenylacryloyl)oxy]-2,2-bis[[(2-cyano-3,3-diphenylacryloyl)oxy]methyl]propane; hindered amino light stabilizers (HALS), nano-size inorganic materials such as titanium oxide, cerium oxide, and zinc oxide, all with particle size less than 100 nanometers; or the like, or combinations including at least one of the foregoing UV absorbers. UV absorbers are generally used in amounts of 0.01 to 3.0 parts by weight, based on 100 parts by weight of the total thermally conductive composition, excluding any filler.

Suitable lubricants comprise for example, fatty acid esters such as alkyl stearyl esters, e.g., methyl stearate or the like; mixtures of methyl stearate and hydrophilic and hydrophobic surfactants including polyethylene glycol polymers, polypropylene glycol polymers, and copolymers thereof e.g., methyl stearate and polyethylene-polypropylene glycol copolymers in a suitable solvent; fatty amides such as ethylene bis stearamide (EBS), or the like, or a combination comprising at least one of the foregoing lubricants. Lubricants are generally used in amounts of from 0.1 to 5 parts by weight, based on 100 parts by weight of the thermally conductive total composition, excluding any filler.

Suitable blowing agents comprise for example, low boiling halohydrocarbons and those that generate carbon dioxide; blowing agents that are solid at room temperature and when heated to temperatures higher than their decomposition temperature, generate gases such as nitrogen, carbon dioxide, ammonia gas, such as azodicarbonamide, metal salts of azodicarbonamide, 4,4' oxybis(benzenesulfonylhydrazide), sodium bicarbonate, ammonium carbonate, or the like, or a combination comprising at least one of the foregoing blowing agents. Blowing agents are generally used in amounts of from 1 to 20 parts by weight, based on 100 parts by weight of the total thermally conductive composition, excluding any filler.

Additionally, materials to improve flow and other properties may be added to the composition, such as low molecular weight hydrocarbon resins. Particularly useful classes of low molecular weight hydrocarbon resins are those derived from petroleum C₅ to C₉ feedstock that are derived from unsaturated C₅ to C₉ monomers obtained from petroleum cracking. Non-limiting examples comprise olefins, e.g. pentenes, hexenes, heptenes and the like; diolefins, e.g. pentadienes, hexadienes and the like; cyclic olefins and diolefins, e.g. cyclopentene, cyclopentadiene, cyclohexene, cyclohexadiene, methyl cyclopentadiene and the like; cyclic diolefin dienes, e.g., dicyclopentadiene, methylcyclopentadiene dimer and the like; and aromatic hydrocarbons, e.g. vinyltoluenes, indenes, methylindenes and the like. The resins can additionally be partially or fully hydrogenated. Hyperbranched polymers (e.g., dendrimers) are another class of additives that are known to improve flow. Non-limiting examples include hyperbranched polyesters such as BOLTORN® H20 and H30 or the hyperbranched polyester-amides sold under the trademark HYBRANE® and commercially available from DSM.

The thermally conductive compositions can be readily formed using methods that involve dispersing one or more fillers in a thermoplastic polymer. The thermally conductive compositions can generally be processed by a melt compounding process or solution blending process.

There is no particular limitation on the method by which the thermally conductive compositions may be prepared. For example, the ingredients may be placed into an extrusion compounder with the thermoplastic polymer to produce molding pellets. Alternatively, the ingredients may be mixed with a thermoplastic polymer by dry blending, then either fluxed on a mill and comminuted, or extruded and chopped. Further, the ingredients may also be mixed with powder or granular thermoplastic polymer and directly molded, e.g., by injection or transferred molding techniques.

The flame retardant fillers, anti-dripping agents and char-forming agents and fillers or reinforcing agents and any other additives may first be dry blended together, then fed into an extruder from one or multi-feeders, or separately fed into extruder from one or multi-feeders. The organic polymer or any polymeric combination may be first dry blended with each other, or dry blended with any combination of foregoing mentioned fillers or additives, then fed into an extruder from one or multiple-feeders. The fillers may also be first processed into a masterbatch, then fed into the extruder. The ingredients may be fed into the throat of the extruder or into a side-feeder and then into the extruder.

The extruders used may have a single screw, multiple screws, intermeshing co-rotating or counter rotating screws, non-intermeshing co-rotating or counter rotating screws, reciprocating screws, screws with pins, screws with screens, barrels with pins, rolls, rams, helical rotors, or combinations including at least one of the foregoing. The melt blending of the composites involves the use of shear force, extensional force, compressive force, ultrasonic energy, electromagnetic energy, thermal energy or combinations including at least one of the foregoing forces or forms of energy.

The barrel temperature on the extruder during compounding can be set at the temperature where at least a portion of the organic polymer has reached a temperature greater than or equal to about the melting temperature if the polymer is a semi-crystalline organic polymer, or the flow point (e.g., the glass transition temperature) if the polymer is an amorphous polymer.

The moldable thermally conductive composition including the foregoing mentioned organic polymer and the fillers may be subject to multiple blending and forming steps if desirable. For example, the moldable thermally conductive composition may first be extruded and formed into pellets. The pellets may then be fed into a molding machine where it may be formed into any desirable shape or product. Alternatively, the moldable thermally conductive composition emanating from a single melt blender may be formed into sheets or strands and subjected to post-extrusion processes such as annealing, uniaxial or biaxial orientation.

Solution blending may also be used to manufacture the moldable thermally conductive composition. The solution blending may also use additional energy such as shear, compression, ultrasonic vibration, or the like, to promote homogenization of fillers with the organic polymer. In some embodiments, an organic polymer suspended in a fluid may be introduced into an ultrasonic sonicator along with any foregoing fillers. The mixture may be solution blended by sonication for a time period effective to disperse the fillers into the organic polymers. The organic polymer along with the fillers may then be dried, extruded and molded if desired.

The thermally conductive compositions can be formed into moldable stock material or moldable articles using techniques known to those in the art.

Flame retardancy was performed in accordance with UL-94 guidelines on calibrated equipment. Thermal conductivity, (κ, W/m-K), is measured by either Nanoflash or Hotdisk equipment. The Nanoflash LFA447 method is using a pyroceram reference with similar thickness. The measurement determines the thermal diffusivity (α,. cm²/s) and the specific heat (Cp, J/g-K) of the sample, together with the density (ρ,. g/cm³), which is measured using a water immersion method (ASTM D792), the product of three value gives the thermal conductivity in the through plane direction and in plane direction, according to: κ = α(T) Cp(T) ρ(T). A Hotdisk TPS2500 apparatus equipped with a 6mm radius sensor was used in the anisotropic mode, yielding the through-plane and in-plane thermal conductivity. The specific heat needed as input parameter for the anisotropic measurement was measured on the specific heat module using the same Hotdisk TPS 2500 apparatus. All measurements were performed under controlled conditions (23°C and 50% RH).

The thermally conductive compositions can be formed into an article of manufacture. In some embodiments the article can be a molded article. In some embodiments, the thermally conductive compositions and articles herein can be used in heat or thermal dissipation management applications where electrical insulation is desired. Examples comprise, but are not limited to, heat sinks for electronic components in computers and consumer electrical appliances, solar cells and batteries such as processors, lamps, LED-lamps, electric motors, electric circuits, the encapsulation of electronics, such as coils or casings, solar cell back sheets, battery casings, or the manufacture of heat exchangers for highly problematic (corrosive) environments.

Flammability tests were performed following the procedure of Underwriter's Laboratory Bulletin 94 entitled "Tests for Flammability of Plastic Materials, UL 94". Several ratings can be applied based on the rate of burning, time to extinguish, ability to resist dripping, and whether or not drips are burning. Samples for testing are bars having dimensions of 125 mm length×13 mm width by no greater than 13 mm thickness. Bar thicknesses were 0.6 mm or 0.8 mm. Materials can be classified according to this procedure as UL 94 HB (horizontal burn), V0, V1, V2, 5VA and/or 5VB on the basis of the test results obtained for five samples; however, the compositions herein were tested and classified only as V0, V1, and V2, the criteria for each of which are described below.
V0: In a sample placed so that its long axis is 180 degrees to the flame, the period of flaming and/or smoldering after removing the igniting flame does not exceed ten (10) seconds and the vertically placed sample produces no drips of burning particles that ignite absorbent cotton. Five bar flame out time is the flame out time for five bars, each lit twice, in which the sum of time to flame out for the first (t1) and second (t2) ignitions is less than or equal to a maximum flame out time (t1+t2) of 50 seconds.
V1: In a sample placed so that its long axis is 180 degrees to the flame, the period of flaming and/or smoldering after removing the igniting flame does not exceed thirty (30) seconds and the vertically placed sample produces no drips of burning particles that ignite absorbent cotton. Five bar flame out time is the flame out time for five bars, each lit twice, in which the sum of time to flame out for the first (t1) and second (t2) ignitions is less than or equal to a maximum flame out time (t1+t2) of 250 seconds.
V2: In a sample placed so that its long axis is 180 degrees to the flame, the average period of flaming and/or smoldering after removing the igniting flame does not exceed thirty (30) seconds, but the vertically placed samples produce drips of burning particles that ignite cotton. Five bar flame out time is the flame out time for five bars, each lit twice, in which the sum of time to flame out for the first (t1) and second (t2) ignitions is less than or equal to a maximum flame out time (t1+t2) of 250 seconds.

In an embodiment, the flame retardant polycarbonate compositions are of particular utility in the manufacture flame retardant articles that pass the UL94 vertical burn tests, in particular the UL94 5VB standard. In the UL94 vertical burn test, a flame is applied to a vertically fastened test specimen placed above a cotton wool pad. To achieve a rating of 5VB, burning must stop within 60 seconds after five applications of a flame to a test bar, and there can be no drips that ignite the pad. Various embodiments of the compositions described herein meet the UL94 5VB standard.

The thermally conductive compositions have a flame retardancy of V-0, V-1, or V-2, at various thicknesses when tested according to the UL-94 protocol. The sample thickness can be 0.1 millimeter or less, 0.3 millimeter or less, specifically 0.4 millimeter or less, specifically 0.8 millimeter or less, specifically 1.0 mm or less, specifically 1.2 mm or less, specifically 1.5 mm or less, specifically 1.8 mm or less, specifically 2.0 mm or less, specifically 3.0 mm or less.

In some embodiments, the flame retardant composition has a flame retardancy of V-0 at a thickness of 0.8 millimeters when measured as per UL-94 protocol. In another embodiment, the flame retardant composition has a flame retardancy of V-0 at a thickness of 1.0 millimeters when measured as per UL-94 protocol. In yet another embodiment, the flame retardant composition has a flame retardancy of V-0 at a thickness of 1.2 millimeters when measured as per UL-94 protocol. In yet another embodiment, the flame retardant composition has a flame retardancy of V-0 at a thickness of 1.6 millimeters when measured as per UL-94 protocol.

The present invention is further illustrated by the following non-limiting examples.

### EXAMPLES

Table 1 below provides a general description of the materials used in this application. These examples were conducted to demonstrate the effect of metal hydroxides and polysiloxanes on the thermal conductivity of the thermally conductive composition.

**Table 1**

| COMPONENT | CHEMICAL DESCRIPTION | SOURCE |
|---|---|---|
| MAGNIFIN H-5 IV | Mg(OH)2 [CAS: 1309-42-8] | Martinswerk |
| PPG 3540 1/8" | Glass Fiber (GF) [CAS: 65997-17-3] | PPG |
| ULTRAMID B27 | Nylon 6 (PA6) [CAS: 25038-54-4] | BASF |
| Polyamide Polymer PA66 | Nylon 6,6 (PA66) [CAS: 32131-17-2] | Rhodia Polyamide Intermediates |
| FORTRON W-214A | PPS [CAS: 26125-40-6] | Polyplastics Co.,Ltd |
| PPO | PPE [CAS:25134-01-4] | Sabic Innovative Plastics |
| ULTEM 1010 | PEI [CAS: 61128-46-9] | Sabic Innovative Plastics |
| Dimethyl siloxane polymer | Polydimethylsiloxane (PDMS) [CAS: 63148-62-9] | GE Plastics |
| TEGOMER ANTISCRATCH 200 | Compound of an organic modified siloxane (Polyamide based siloxane compounds (PBSC)) | Evonik |
| Joncryl® ADR 4368 CS | Modified styrene acrylic polymers chain extender. | BASF |
| Domamid 24 | Nylon 6 (PA6) [CAS: 25038-54-4] | Domo |
| Polyphenylene ether/Nylon 6 | Masterbatch made in-house at Sabic Innovative Plastics | Sabic Innovative Plastics |
| GF 3660 | Glass Fiber (GF) [CAS: 9003-56-9] | PPG |
| PETS | pentaerythritol tetrastearate [CAS: 115-83-3 | Lonza |
| Irganox 1098 | N,N'-Hexamethylene bis (3,5-di-t-butyl-4-hydroxyhydrocinnamamide) [CAS:23128-74-7] | Ciba |
| Irgafos 168 | Tris(di-t-butylphenyl)phosphite, secondary antioxidant [CAS:31570-04-4] | Ciba |
| Fortron B4 powder | Polyphenylene Sulfide (PPS) | Ticona |
| Grade 2012 graphite | Graphite [CAS: 7782-42-5] | Asbury |

Table 2 and 3 show the set temperatures used during the compounding and molding operations. The extrusion was conducted on a twin screw extruder having 10 barrels and a die. Extrusion conditions are shown in the Table 2. As can be seen in the Table 2, comparative samples (C1 and Sample #1) and Sample #s 2 - 5 were extruded under one set of conditions, while comparative sample (C2) and Sample #s 6 - 7 were extruded under another set of conditions. Comparative sample (C3) and Sample #s 8 - 9 were extruded under yet another set of conditions. All three sets of conditions are shown in the Table 2 below.

**Table 2**

| Set temperatures | | C1, #1-#5 | C2, #6 - #7 | C3, #8 - #9 |
|---|---|---|---|---|
| Intake Zone Temp | °C | 50 | 50 | 50 |
| Zone 1 Temp (intake) | °C | 150 | 150 | 150 |
| Zone 2 Temp | °C | 240 | 240 | 260 |
| Zone 3 Temp | °C | 240 | 240 | 260 |
| Zone 4 Temp | °C | 240 | 240 | 260 |
| Zone 5 Temp | °C | 240 | 240 | 260 |
| Zone 6 Temp | °C | 240 | 240 | 260 |
| Zone 7 Temp | °C | 240 | 240 | 260 |
| Zone 8 Temp | °C | 230 | 240 | 260 |
| Zone 9 Temp | °C | 230 | 230 | 240 |
| Zone 10 Temp | °C | 230 | 230 | 240 |
| Zone 11 Temp (die) | °C | 250 | 230 | 240 |
| Screw Speed | rpm | 300 | 300 | 300 |

Molding conditions are shown in the Table 3 below. Comparative Examples 1 (C1 and Sample #1) and Sample Nos. #2, #3, #4 and #5, were molded under one set of conditions shown below, while Comparative Example 2 (C2) and 3(C3) and Sample Nos. #6, #7, #8, and #9, were molded in the form of bars under another set of conditions shown in the Table 3 below.

**Table 3**

| | | C1, #1, #2, #3, #4, #5 | **C2, C3, #6, #7, #8, #9** |
|---|---|---|---|
| Drying time | (hrs) | 4 | 4 |
| Drying Temperature | (°C) | 80 | 80 |
| T hopper | (°C) | 50 | 50 |
| T zone 1 | (°C) | 270 | 280 |
| T zone 2 | (°C) | 270 | 280 |
| T zone 3 | (°C) | 270 | 280 |
| T nozzle | (°C) | 270 | 280 |
| T mold | (°C) | 100 | 100 |

Tables 4 through 6 below provide details of the compositions as well as the comparative flame performance and thermal conductivity results of the thermally conductive composites with and without a siloxane-based auxiliary FR-package. In Tables 4 - 6, the comparative compositions contain a nylon 6, magnesium hydroxide, and glass fibers with no PBSC, PDMS and chain extender 4368CS or with no PDMS and carboxyl chain extender 4368CS. The inventive compositions (Samples #2 - #5) contain either PBSC (a polyamide based polysiloxane compound), or PDMS in addition to the chain extender 4368CS.

**Table 4**

| Example No. | Domamid 27 (PA6) (wt%) | Mg(OH)₂ (wt%) | PBSC (wt%) | PDMS (wt%) | 4368CS (wt%) | GF (wt%) | UL-94 Flame rating | Average K± (W/(m^{∗}K)) |
|---|---|---|---|---|---|---|---|---|
| C1 | 35 | 55 | | | | 10 | V-2 @1.2mm | 1.08 |
| 1 | 34.5 | 55 | 0.5 | | | 10 | V-2@ 1.2mm | 1.2 |
| 2 | 34.25 | 55 | 0.5 | | 0.25 | 10 | V-1 @1.2mm | 1.18 |
| 3 | 33.75 | 55 | 1 | | 0.25 | 10 | V-0 @1.2mm | 1.19 |
| 4 | 32.75 | 55 | 2 | | 0.25 | 10 | V-0 @1.2mm | 1.16 |
| 5 | 32.75 | 55 | | 2 | 0.25 | 10 | V-0 @1.2mm | 1.29 |

**Table 5**

| | Flame test after 48 hours/23°C aging | | | |
|---|---|---|---|---|
| Example No. | No. of Burning Drops | P(FTP) V0 | P(FTP) V1 | FOT 5 (s) |
| C1 | 2 | 0.28 | 0.28 | 23.05 |
| 1 | 0 | 1 | 1 | 18.25 |
| 2 | 0 | 0.55 | 0.98 | 33.05 |
| 3 | 0 | 0.9 | 1 | 24.95 |
| 4 | 0 | 1 | 1 | 15.9 |
| 5 | 0 | 0.99 | 1 | 20.45 |

**Table 6**

| | Flame test after 168 hours/70°C aging | | | |
|---|---|---|---|---|
| Example No. | No. of Burning Drops | P(FTP) V0 | P(FTP) V1 | FOT 5 (s) |
| C1 | 3 | 0.11 | 0.11 | 21.75 |
| 1 | 1 | 0.57 | 0.57 | 20.85 |
| 2 | 0 | 0.99 | 1 | 19.45 |
| 3 | 0 | 1 | 1 | 17.2 |
| 4 | 0 | 0.99 | 1 | 19.3 |
| 5 | 0 | 1 | 1 | 18.2 |

From the Tables 4 - 6, it may be seen that Comparative examples (C1 and Sample #1) and Sample #s 2 - 5 show the comparative flame performance and thermal conductivity results for the thermally conductive compositions using different combination of silicone char-forming agents and anti-flame dripping agent. As can be seen from comparative example C1, for Nylon 6 base polymer, with only 55 wt% of magnesium hydroxide as flame retardant, the sample displays a flame retardancy of V-2 @1.2mm thickness, and although flame time is good and short enough, there is a flame dripping and a cotton ignition issue.

With addition of 0.5 wt% of char-forming agent PBSC as seen in Sample #1, there is an improvement in flame time, but there is still a flame dripping problem. Further with addition of anti-flame dripping agent of 4368CS as in Sample # 2, it can be seen that the dripping issue is resolved, and the flame retardancy is improved to V-1 @1.2mm thickness.

In order to get a V-0 flame performance, a higher quantity of char-forming agent was loaded, as in Sample #s 3 and 4. This provides a further improvement in flame time and no flame dripping occurred, while robust V-0 flame performance was obtained.

By replacing char-forming agent PBSC with the commonly used PDMS in Sample # 5, the composition attains a robust V-0 flame performance.

Due to addition of inorganic metal hydroxide in the composites with high loading, high thermal conductivity was obtained for all examples, and addition of the other flame retardant enhancing components showed no big influence on composites' thermal conductivity.

### Example 2

The Tables 7 - 9 detail compositions that contain the same ingredients as the samples shown in Tables 4 - 6, with the exception that the weight percentages are different and the compositions contain an antidrip agent notably polytetrafluoroethylene (PTFE). Table 7 details the composition, while Tables 8 and 9 detail the respective properties. The comparative composition (C2) does not contain any PTFE or PDMS. P(FTP) refers to the probability of a first time pass.

**Table 7**

| Example No. | Domamid 27 (PA6) (wt%) | Mg (OH)2 (wt%) | PTFE (wt%) | PDMS (wt%) | GF (wt%) | UL-94 Flame rating | Average K± (W/(m^{∗}K)) |
|---|---|---|---|---|---|---|---|
| C2 | 32 | 58 | | | 10 | V-2 1.0mm | 1.4 |
| 6 | 31.7 | 58 | 0.3 | | 10 | V-2 @1.0mm | 1.2 |
| 7 | 31.2 | 58 | 0.3 | 0.5 | 10 | V-0 @1.0mm | 1.4 |

Table 8 details the properties after 48 hours of aging at 23°C, while Table 9 details the properties after 168 hours of aging at 70°C.

**Table 8**

| | Flame test after 48 hours/23°C aging | | | |
|---|---|---|---|---|
| Example No. | No. of Burning Drops | P(FTP) V-0 | P(FTP) V-1 | FOT 5 (s) |
| C2 | 3 | 0.11 | 0.11 | 14.4 |
| 6 | 0 | 1.00 | 1.00 | 16.2 |
| 7 | 0 | 1.00 | 1.00 | 13.6 |

**Table 9**

| | Flame test after 168 hours/70°C aging | | | |
|---|---|---|---|---|
| Example No. | No. of Burning Drops | P(FTP) V-0 | P(FTP) V-1 | FOT 5 (s) |
| C2 | 4 | 0.03 | 0.03 | 12.35 |
| 6 | 2 | 0.28 | 0.28 | 14.2 |
| 7 | 0 | 1.00 | 1.00 | 14.8 |

From the Table 8 it may be seen that the samples that contain PTFE and/or PDMS show a P(FTP) of 1.0, while the comparative compositions (i.e., C2) do not show the same flame retardant behavior.

### Example 3

The Tables 10 - 12 detail compositions that contain a blend of nylon 6 (Domanid) and nylon 66. The inventive compositions contain an antidrip agent notably polytetrafluoroethylene (PTFE), while the comparative composition (C3) does not. Table 10 details the composition, while Tables 11 and 12 detail the respective properties. P(FTP) refers to the probability of a first time pass.

**Table 10**

| Example No. | Domamid 27 (PA6) (wt%) | PA66 (wt%) | Mg(OH)₂ (wt%) | PTFE (wt%) | PDMS (wt%) | GF (wt%) | UL-94 Flame rating | Average K± (W/(m^{∗}K)) |
|---|---|---|---|---|---|---|---|---|
| C3 | 19.5 | 12.5 | 58 | | | 10 | V-2 @0.6mm | 1.4 |
| 8 | 19.2 | 12.5 | 58 | | 0.5 | 10 | V-2 @0.6mm | 1.4 |
| 9 | 18.7 | 12.5 | 58 | 0.3 | 0.5 | 10 | V-0 @0.6mm | 1.4 |

**Table 11**

| | Flame test after 48 hours/23°C aging | | | |
|---|---|---|---|---|
| Example No. | No. of Burning Drops | P(FTP) V0 | P(FTP) V1 | FOT 5 (s) |
| C3 | 1 | 0.57 | 0.57 | 21.55 |
| 8 | 2 | 0.28 | 0.28 | 14.2 |
| 9 | 0 | 1.00 | 1.00 | 17.76 |

**Table 12**

| | Flame test after 168 hours/70°C aging | | | |
|---|---|---|---|---|
| Example No. | No. of Burning Drops | P(FTP) V0 | P(FTP) V1 | FOT 5 (s) |
| C3 | 0 | 1.00 | 1.00 | 18.95 |
| 8 | 0 | 1.00 | 1.00 | 14.95 |
| 9 | 0 | 1.00 | 1.00 | 16.6 |

Table 11 details the properties after 48 hours of aging at 23°C, while Table 12 details the properties after 168 hours of aging at 70°C. From the Tables 11 and 12 it may be seen that the samples that contain PTFE and/or PDMS (the silicone char forming agent) show a P(FTP) of 1.0, while the comparative composition (C3) does not show the same flame retardant behavior.

## Claims

1. A thermally conductive composition, comprising:
20 to 80 wt% of a thermoplastic or thermosetting polymer;
10 to 70 wt% of a metal hydroxide;
0.5 to 40 wt% of a silicone char-forming agent, wherein the silicone char-forming agent is an organopolysiloxane selected from polyalkylsiloxane, polyalkylarylsiloxane, polyarylsiloxane, or a combination comprising at least one of the foregoing organopolysiloxanes, or an organopolysiloxane copolymer selected from a polycarbonate-polysiloxane copolymer, a polyamide-polysiloxane copolymer, a polyester-polysiloxane copolymer, a polymethacrylate-polysiloxane copolymer, a polyetherimide-polysiloxane copolymer, a polyphenylene-ether-polysiloxane copolymer, or a combination comprising at least one of the foregoing copolymers; and
0.05 to 5 wt% of an anti-flame dripping agent,
wherein the anti-flame dripping agent is a multi-functional modified styrene-acrylic oligomeric chain extender, a multi-functional amino or carboxyl chain extender, a combination of poly(tetrafluoroethylene) and a styrene-acrylonitrile copolymer, or a combination comprising at least one of the foregoing anti-flame dripping agents;
wherein the thermally conductive composition has a thermal conductivity of at least 0.5 W/mK for through plane thermal conductivity; and a flame retardancy of at least V-0 performance at a thickness of 1.2 mm or less when tested as per a UL-94 testing standard.

2. The thermally conductive composition of claim 1, further comprising 5 to 60 wt% of a filler or a reinforcing agent.

3. The thermally conductive composition of any one of claims 1 and 2, wherein the thermoplastic polymer is a polypropylene, a polyethylene, an ethylene based copolymer, a polycarbonate, a polyamide, a polyester, a polybutylene terephthalate, a polyethylene terephthalate, a polycyclohexylenedimethylene terephthalate, a liquid crystal polymer, a polystyrene, a modified high impact polystyrene, an acrylonitrile-butadiene-styrene terpolymer, a (meth)acryl polymer, a polyurethane, or a combination comprising at least one of the foregoing thermoplastic polymers.

4. The thermally conductive composition of any one of claims 1 through 3, wherein the metal hydroxide is Mg(OH)₂, γ-AlO(OH), α-AlO(OH), Al(OH)₃ or a combination comprising at least one of the foregoing metal hydroxides.

5. The thermally conductive composition of any one of claims 1 through 4, where the reinforcing agent comprises glass fibers.

6. The thermally conductive composition of any one of claims 1 through 5, wherein the reinforcing agent has a thermal conductivity greater than or equal to 50 W/mK, and comprises AlN, Al₄C₃, Al₂O₃, BN, AlON, MgSiN₂, SiC, Si₃N₄, graphite, expanded graphite, graphene, carbon fiber, or a combination comprising at least one of the foregoing reinforcing agents that have a thermal conductivity of greater than or equal to 50 W/mK; the reinforcing agent has a thermal conductivity of 10 to 30 W/mK, and comprises ZnS, CaO, MgO, ZnO, TiO₂, or a combination comprising at least one of the foregoing reinforcing agents that have a thermal conductivity of 10 to 30 W/mK; or the reinforcing agent has a thermal conductivity lower than 10 W/mK, and comprises CaCO₃, mica, BaO, BaSO₄, CaSiO₃, ZrO₂, SiO₂, glass beads, glass fiber, MgO·xAl₂O₃, CaMg(CO₃)₂, H₂Mg₃(SiO₃)₄, ceramic-coated graphite, clay, or a combination comprising at least one of the foregoing reinforcing agents that have a thermal conductivity lower than 10 W/mK.

7. The thermally conductive composition of any one of claims 1 through 6, wherein the composition further comprises from 1 to 10 wt% of a pigment, a colorant, a dye, a processing additive, or a combination thereof.

8. The thermally conductive composition any one of claims 1, 2 and 4 through 7, wherein the thermosetting polymer is an epoxy polymer, an unsaturated polyester polymer, a polyimide polymer, a bismaleimide polymer, a bismaleimide triazine polymer, a cyanate ester polymer, a vinyl polymer, a benzoxazine polymer, a benzocyclobutene polymer, a (meth)acryl polymer, an alkyd polymer, a phenol-formaldehyde polymer, a novolac polymer, a resole polymer, a melamine-formaldehyde polymer, a urea-formaldehyde polymer, a hydroxymethylfuran polymer, an isocyanate polymer, a diallyl phthalate polymer, a triallyl cyanurate polymer, a triallyl isocyanurate polymer, an unsaturated polyesterimide, or a combination comprising at least one of the foregoing thermosetting polymers.

9. An article comprising the composition any one of claims 1 through 8.

10. A method comprising:
blending 20 to 80 wt% of a thermoplastic or thermosetting polymer; 10 to 70 wt% of a metal hydroxide; 0.5 to 40 wt% of a silicone char-forming agent, and 0.05 to 5 wt% of an anti-flame dripping agent; wherein the thermally conductive composition has a thermal conductivity of at least 0.5 W/mK for through plane thermal conductivity; and a flame retardancy of at least V-0 performance at a thickness of 1.2 mm or less when tested as per a UL-94 testing standard, and
wherein the silicone char-forming agent is an organopolysiloxane selected from polyalkylsiloxane, polyalkylarylsiloxane, polyarylsiloxane, or a combination comprising at least one of the foregoing organopolysiloxanes, or an organopolysiloxane copolymer selected from a polycarbonate-polysiloxane copolymer, a polyamide-polysiloxane copolymer, a polyester-polysiloxane copolymer, a polymethacrylate-polysiloxane copolymer, a polyetherimide-polysiloxane copolymer, a polyphenylene-ether-polysiloxane copolymer, or a combination comprising at least one of the foregoing copolymers, and
wherein the anti-flame dripping agent is a multi-functional modified styrene-acrylic oligomeric chain extender, a multi-functional amino or carboxyl chain extender, a combination of poly(tetrafluoroethylene) and a styrene-acrylonitrile copolymer, or a combination comprising at least one of the foregoing anti-flame dripping agents.

11. The method of Claim 10, further comprising molding the thermally conductive composition.

## Patentansprüche

1. Wärmeleitende Zusammensetzung, umfassend:
20 bis 80 Gew.-% eines thermoplastischen oder duroplastischen Polymers;
10 bis 70 Gew.-% eines Metallhydroxids;
0,5 bis 40 Gew.-% eines Silikonkohle bildenden Mittels, wobei das Silikonkohle bildende Mittel ein Organopolysiloxan ist, ausgewählt aus Polyalkylsiloxan, Polyalkylarylsiloxan, Polyarylsiloxan, oder einer Kombination, die mindestens eines der vorstehend genannten Organopolysiloxane umfasst, oder ein Organopolysiloxan-Copolymer, ausgewählt aus einem Polycarbonat-Polysiloxan-Copolymer, einem Polyamid-Polysiloxan-Copolymer, einem Polyester-Polysiloxan-Copolymer, einem Polymethacrylat-Polysiloxan-Copolymer, einem Polyetherimid-Polysiloxan-Copolymer, einem Polyphenylen-Ether-Polysiloxan-Copolymer, oder einer Kombination, die mindestens eines der vorstehend genannten Copolymere umfasst; und
0,05 bis 5 Gew.-% eines Flamm-/Tropfschutzmittels,
wobei das Flamm-/Tropfschutzmittel ein multifunktioneller modifizierter styrol-akrylischer oligomerer Kettenverlängerer, ein multifunktioneller Amino- oder Carboxyl-Kettenverlängerer, eine Kombination aus Poly(tetrafluorethylen) und einem Styrol-Acrylonitril-Copolymer, oder eine Kombination ist, die mindestens eines der vorstehend genannten Flamm-/Tropfschutzmittel umfasst;
wobei die wärmeleitende Zusammensetzung eine Wärmeleitfähigkeit von mindestens 0,5W/mK bei Through-Plane-Wärmeleitfähigkeit; und eine Flammhemmung von mindestens Leistung V-0 bei einer Dicke von 1,2 mm oder weniger aufweist, wenn gemäß einer UL-94 Prüfnorm geprüft.

2. Wärmeleitende Zusammensetzung nach Anspruch 1, weiter 5 bis 60 Gew.-% eines Füllstoffs oder eines Verstärkungsmittels umfassend.

3. Wärmeleitende Zusammensetzung nach einem der Ansprüche 1 und 2, wobei das thermoplastische Polymer ein Polypropylen, ein Polyethylen, ein Copolymer auf Ethylenbasis, ein Polycarbonat, ein Polyamid, ein Polyester, ein Polybutylenterephthalat, ein Polyethylenterephthalat, ein Polycyclohexylendimethylenterephthalat, ein Flüssigkristallpolymer, ein Polystyrol, ein modifiziertes hochschlagfestes Polystyrol, ein Acrylonitril-Butadien-Styrol-Terpolymer, ein (Meth)acryl-Polymer, ein Polyurethan, oder eine Kombination ist, die mindestens eines der vorstehend genannten thermoplastischen Polymere umfasst.

4. Wärmeleitende Zusammensetzung nach einem der Ansprüche 1 bis 3, wobei das Metallhydroxid Mg(OH)₂, γ-AlO(OH), α-AlO(OH), Al(OH)₃ oder eine Kombination ist, die mindestens eines der vorstehend genannten Metallhydroxide umfasst.

5. Wärmeleitende Zusammensetzung nach einem der Ansprüche 1 bis 4, wobei das Verstärkungsmittel Glasfasern umfasst.

6. Wärmeleitende Zusammensetzung nach einem der Ansprüche 1 bis 5, wobei das Verstärkungsmittel eine Wärmeleitfähigkeit von größer als oder gleich 50 W/mK aufweist und AlN, Al₄C₃, Al₂O₃, BN, AION, MgSiN₂, SiC, Si₃N₄, Graphit, expandierten Graphit, Graphen, Kohlenstofffaser, oder eine Kombination umfasst, die mindestens eines der vorstehend genannten Verstärkungsmittel umfasst, welche eine Wärmeleitfähigkeit von größer als oder gleich 50 W/mK aufweisen; das Verstärkungsmittel eine Wärmeleitfähigkeit von 10 bis 30 W/mK aufweist und ZnS, CaO, MgO, ZnO, TiO₂ oder eine Kombination umfasst, die mindestens eines der vorstehend genannten Verstärkungsmittel umfasst, welche eine Wärmeleitfähigkeit von 10 bis 30 W/mK aufweisen; oder das Verstärkungsmittel eine Wärmeleitfähigkeit von weniger als 10 W/mK aufweist und CaCO₃, Glimmer, BaO, BaSO₄, CaSiO₃, ZrO₂, SiO₂, Glaskügelchen, Glasfaser, MgO•xAl₂O₃, CaMg(CO₃)₂, H₂Mg₃(SiO₃)₄, keramikbeschichteten Graphit, Ton oder eine Kombination umfasst, die mindestens eines der vorstehend genannten Verstärkungsmittel umfasst, welche eine Wärmeleitfähigkeit von kleiner als 10 W/mK aufweisen.

7. Wärmeleitende Zusammensetzung nach einem der Ansprüche 1 bis 6, wobei die Zusammensetzung weiter 1 bis 10 Gew.-% eines Pigments, eines Farbstoffs, eines Färbemittels, eines Verarbeitungsadditivs oder einer Kombination davon umfasst.

8. Wärmeleitende Zusammensetzung nach einem der Ansprüche 1, 2 und 4 bis 7, wobei das duroplastische Polymer ein Epoxidpolymer, ein ungesättigtes Polyesterpolymer, ein Polyimidpolymer, ein Bismaleimidpolymer, ein Bismaleimidtriazinpolymer, ein Cyanatesterpolymer, ein Vinylpolymer, ein Benzoxazinpolymer, ein Benzocyclobutenpolymer, ein (Meth)acrylpolymer, ein Alkydpolymer, ein Phenolformaldehydpolymer, ein Novolacpolymer, ein Resolpolymer, ein Melaminformaldehydpolymer, ein Harnstoffformaldehydpolymer, ein Hydroxymethylfuranpolymer, ein Isocyanatpolymer, ein Diallylphthalatpolymer, ein Triallylcyanuratpolymer, ein Triallylisocyanuratpolymer, ein ungesättigtes Polyesterimid, oder eine Kombination ist, die mindestens eines der vorstehend genannten duroplastischen Polymere umfasst.

9. Erzeugnis, das die Zusammensetzung nach einem der Ansprüche 1 bis 8 umfasst.

10. Verfahren, umfassend:
Mischen von 20 bis 80 Gew.-% eines thermoplastischen oder duroplastischen Polymers; 10 bis 70 Gew.-% eines Metallhydroxids; 0,5 bis 40 Gew.-% eines Silikonkohle bildenden Mittels, und 0,05 bis 5 Gew.-% eines Flamm-/Tropfschutzmittels; wobei die wärmeleitende Zusammensetzung eine Wärmeleitfähigkeit von mindestens 0,5 W/mK bei Through-Plane-Wärmeleitfähigkeit; und eine Flammhemmung von mindestens Leistung V-0 bei einer Dicke von 1,2 mm oder weniger aufweist, wenn gemäß einer UL-94 Prüfnorm geprüft, und
wobei das Silikonkohle bildende Mittel ein Organopolysiloxane ist, ausgewählt aus Polyalkylsiloxan, Polyalkylarylsiloxan, Polyarylsiloxan, oder einer Kombination, die mindestens eines der vorstehend genannten Organopolysiloxane umfasst, oder ein Organopolysiloxan-Copolymer, ausgewählt aus einem Polycarbonat-Polysiloxan-Copolymer, einem Polyamid-Polysiloxan-Copolymer, einem Polyester-Polysiloxan-Copolymer, einem Polymethacrylat-Polysiloxan-Copolymer, einem Polyetherimid-Polysiloxan-Copolymer, einem Polyphenylen-Ether-Polysiloxan-Copolymer, oder einer Kombination, die mindestens eines der vorstehend genannten Copolymere umfasst, und
wobei das Flamm-/Tropfschutzmittel ein multifunktioneller modifizierter styrol-akrylischer oligomerer Kettenverlängerer, ein multifunktioneller Amino- oder Carboxyl-Kettenverlängerer, eine Kombination aus Poly(tetrafluorethylen) und einem Styrol-Acrylonitril-Copolymer, oder eine Kombination ist, die mindestens eines der vorstehend genannten Flamm-/Tropfschutzmittel umfasst.

11. Verfahren nach Anspruch 10, weiter das Formen der wärmeleitenden Zusammensetzung umfassend.

## Revendications

1. Composition thermoconductrice, comprenant :
20 à 80% en poids d'un polymère thermoplastique ou thermodurcissable ;
10 à 70% en poids d'un hydroxyde métallique ;
0,5 à 40% en poids d'un agent de formation de produit de carbonisation à base de silicone, où l'agent de formation de produit de carbonisation à base de silicone est un organopolysiloxane choisi parmi un polyalkylsiloxane, un polyalkylarylsiloxane, un polyarylsiloxane, ou une combinaison comprenant au moins l'un des organopolysiloxanes précédents, ou un copolymère d'organopolysiloxane choisi parmi un copolymère de polycarbonate-polysiloxane, un copolymère de polyamide-polysiloxane, un copolymère de polyester-polysiloxane, un copolymère de polyméthacrylate-polysiloxane, un copolymère de polyétherimide-polysiloxane, un copolymère de polyphénylène-éther-polysiloxane, ou une combinaison comprenant au moins l'un des copolymères précédents ; et
0,05 à 5% en poids d'un agent contre les égouttures de matière enflammée,
où l'agent contre les égouttures de matière enflammée est un allongeur de chaîne oligomère de styrène-acrylique modifié multifonctionnel, un allongeur de chaîne amino ou carboxyle multifonctionnel, une combinaison de poly(tétrafluoroéthylène) et d'un copolymère styrène-acrylonitrile, ou une combinaison comprenant au moins l'un des agents contre les égouttures de matière enflammée précédents ;
où la composition thermoconductrice a une conductivité thermique d'au moins 0,5 W/mK pour une conductivité thermique à travers le plan ; et un caractère ignifuge de classe au moins V-0 à une épaisseur inférieure ou égale à 1,2 mm lorsqu'elle est testée selon la norme d'essai UL-94.

2. Composition thermoconductrice de la revendication 1, comprenant en outre 5 à 60% en poids d'une charge ou d'un agent de renforcement.

3. Composition thermoconductrice de l'une quelconque des revendications 1 et 2, dans laquelle le polymère thermoplastique est un polypropylène, un polyéthylène, un copolymère à base d'éthylène, un polycarbonate, un polyamide, un polyester, un polybutylène téréphtalate, un polyéthylène téréphtalate, un polycyclohexylènediméthylène téréphtalate, un polymère à cristaux liquides, un polystyrène, un polystyrène à haute résistance au choc modifié, un terpolymère d'acrylonitrile-butadiène-styrène, un polymère (méth)acrylique, un polyuréthane ou une combinaison comprenant au moins l'un des polymères thermoplastiques précédents.

4. Composition thermoconductrice de l'une quelconque des revendications 1 à 3, dans laquelle l'hydroxyde métallique est Mg(OH)₂, γ-AlO(OH), α-AlO(OH), Al(OH)₃ ou une combinaison comprenant au moins l'un des hydroxydes métalliques précédents.

5. Composition thermoconductrice de l'une quelconque des revendications 1 à 4, dans laquelle l'agent de renforcement comprend des fibres de verre.

6. Composition thermoconductrice de l'une quelconque des revendications 1 à 5, dans laquelle l'agent de renforcement a une conductivité thermique supérieure ou égale à 50 W/mK, et comprend AlN, Al₄C₃, Al₂O₃, BN, AlON, MgSiN₂, SiC, Si₃N₄, du graphite, du graphite expansé, du graphène, une fibre de carbone, ou une combinaison comprenant au moins l'un des agents de renforcement précédents qui ont une conductivité thermique supérieure ou égale à 50 W/mK ; l'agent de renforcement a une conductivité thermique allant de 10 à 30 W/mK, et comprend ZnS, CaO, MgO, ZnO, TiO₂, ou une combinaison comprenant au moins l'un des agents de renforcement précédents qui ont une conductivité thermique allant de 10 à 30 W/mK ; ou l'agent de renforcement a une conductivité thermique inférieure à 10 W/mK, et comprend CaCO₃, du mica, BaO, BaSO₄, CaSiO₃, ZrO₂, SiO₂, des billes de verre, une fibre de verre, MgO·xAl₂O₃, CaMg(CO₃)₂, H₂Mg₃(SiO3)₄, du graphite revêtu de céramique, une argile, ou une combinaison comprenant au moins l'un des agents de renforcement précédents qui ont une conductivité thermique inférieure à 10 W/mK.

7. Composition thermoconductrice de l'une quelconque des revendications 1 à 6, dans laquelle la composition comprend en outre 1 à 10% en poids d'un pigment, d'un colorant, d'une teinture, d'un additif de traitement ou d'une combinaison de ceux-ci.

8. Composition thermoconductrice de l'une quelconque des revendications 1, 2 et 4 à 7, dans laquelle le polymère thermodurcissable est un polymère époxy, un polymère de polyester insaturé, un polymère de polyimide, un polymère de bismaléimide, un polymère de bismaléimide triazine, un polymère d'ester de cyanate, un polymère de vinyle, un polymère de benzoxazine, un polymère de benzocyclobutène, un polymère (méth)acrylique, un polymère d'alkyde, un polymère de phénol-formaldéhyde, un polymère novolaque, un polymère de résol, un polymère de mélamine-formaldéhyde, un polymère d'urée-formaldéhyde, un polymère d'hydroxyméthylfurane, un polymère d'isocyanate, un polymère de phtalate de diallyle, un polymère de cyanurate de triallyle, un polymère d'isocyanurate de triallyle, un polyesterimide insaturé, ou une combinaison comprenant au moins l'un des polymères thermodurcissables précédents.

9. Article comprenant la composition de l'une quelconque des revendications 1 à 8.

10. Procédé comprenant le fait :
de mélanger 20 à 80% en poids d'un polymère thermoplastique ou thermodurcissable ; 10 à 70% en poids d'un hydroxyde métallique ; 0,5 à 40% en poids d'un agent de formation de produit de carbonisation à base de silicone, et 0,05 à 5% en poids d'un agent contre les égouttures de matière enflammée ; où la composition thermoconductrice a une conductivité thermique d'au moins 0,5 W/mK pour une conductivité thermique à travers le plan ; et un caractère ignifuge de classe au moins V-0 à une épaisseur inférieure ou égale à 1,2 mm lorsqu'elle est testée selon la norme d'essai UL-94, et
où l'agent de formation de produit de carbonisation à base de silicone est un organopolysiloxane choisi parmi un polyalkylsiloxane, un polyalkylarylsiloxane, un polyarylsiloxane, ou une combinaison comprenant au moins l'un des organopolysiloxanes précédents, ou un copolymère d'organopolysiloxane choisi parmi un copolymère de polycarbonate-polysiloxane, un copolymère de polyamide-polysiloxane, un copolymère de polyester-polysiloxane, un copolymère de polyméthacrylate-polysiloxane, un copolymère de polyétherimide-polysiloxane, un copolymère de polyphénylène-éther-polysiloxane, ou une combinaison comprenant au moins l'un des copolymères précédents, et
où l'agent contre les égouttures de matière enflammée est un allongeur de chaîne oligomère de styrène-acrylique modifié multifonctionnel, un allongeur de chaîne amino ou carboxyle multifonctionnel, une combinaison de poly(tétrafluoroéthylène) et d'un copolymère de styrène-acrylonitrile, ou une combinaison comprenant au moins l'un des agents contre les égouttures de matière enflammée précédents.

11. Procédé de la revendication 10, comprenant en outre le moulage de la composition thermoconductrice.
